(19)

Europäisches
Patentamt
European
Patent Office
Office européen
des brevets

(11) **EP 2 282 620 A1**

(12) **EUROPEAN PATENT APPLICATION**
published in accordance with Art. 153(4) EPC

(43) Date of publication:
**09.02.2011 Bulletin 2011/06**

(51) Int Cl.:
*H05K 1/02* (2006.01)    *H05K 3/28* (2006.01)
*H05K 9/00* (2006.01)

(21) Application number: **09750642.2**

(22) Date of filing: **21.05.2009**

(86) International application number:
**PCT/JP2009/059386**

(87) International publication number:
**WO 2009/142280 (26.11.2009 Gazette 2009/48)**

(84) Designated Contracting States:
**AT BE BG CH CY CZ DE DK EE ES FI FR GB GR
HR HU IE IS IT LI LT LU LV MC MK MT NL NO PL
PT RO SE SI SK TR**
Designated Extension States:
**AL BA RS**

(30) Priority: **22.05.2008 JP 2008134348**

(71) Applicants:
• **Meisei Gakuen**
  **Fuchu-shi, Tokyo 183-0051 (JP)**
• **Shin-Etsu Polymer Co., Ltd.**
  **Tokyo 103-0023 (JP)**

(72) Inventors:
• **OTSUKA Kanji**
  **Higashiyamato-shi**
  **Tokyo 207-0002 (JP)**

• **AKIYAMA Yutaka**
  **Hachiouji-shi**
  **Tokyo 192-0914 (JP)**
• **KAWAGUCHI Toshiyuki**
  **Saitama-shi**
  **Saitama 331-0811 (JP)**
• **TAHARA Kazutoki**
  **Saitama-shi**
  **Saitama 331-0811 (JP)**

(74) Representative: **Berkenbrink, Kai-Oliver et al**
  **Patentanwälte Becker & Müller**
  **Turmstrasse 22**
  **40878 Ratingen (DE)**

(54) **PAIRED LOW-CHARACTERISTIC IMPEDANCE POWER SOURCE LINE AND GROUND LINE STRUCTURE**

(57)    Disclosed is a paired low-characteristic impedance power line and ground line structure in which loop inductance is substantially 0. The paired low-characteristic impedance power line and ground line structure includes a laminated sheet (1) in which a metal wiring layer (20) having a power line (21) and a ground line (22) is provided on the surface of an insulating sheet (10), an insulating thin-film layer (31) provided so as to cover the power line (21) and the ground line (22), and a resistive layer (32) provided on the surface of the insulating thin-film layer (31).

FIG. 2

EP 2 282 620 A1

**Description**

Technical Field

The present invention relates to a paired low-characteristic impedance power line and ground line structure. This application claims priority on Japanese Patent Application No. 2008-134348 filed on May 22, 2008 in the Japanese Patent office, and the disclosure of which is incorporated herein by reference.

Background Art

In electronic circuits, line for supplying high-speed high-power (hereinafter referred to as "power lines") or connections to ground (hereinafter referred to as "ground lines") conventionally use a wide independent wire or a solid wire. When power is supplied through a wide independent wire or a solid wire, a large current easily flows, however frequency characteristics are unsatisfactory, power supply delay occurs during an instantaneous switch operation at a frequency greater than or equal to 1 GHz, and fluctuations of the power source and ground occur in the course of restoration, which adversely affects an adjacent circuit. As is well known in the art, the fluctuations cause the resonance of the power line and ground line, which leads to electromagnetic radiation. The scale of such a problem is expressed as the magnitude of the inductor component (hereinafter, referred to as loop inductance) due to the power source/ground loop circuit. This value is preferably less than or equal to 100 pH at a frequency greater than or equal to 1 GHz. At present, it takes a great deal of effort to reduce loop inductance by inlaying a decoupling capacitor at each location of the circuit board (for example, Patent Citation 1).

[Related Art Citation]

[Patent Citation]

[Patent Citation 1] Japanese Laid-Open Patent Application No. 2006-135036.

Disclosure of Invention

Technical Problem

The present invention has been achieved in consideration of the above-described situation, and it is an object of the present invention to provide a paired low-characteristic impedance power line and ground line structure in which loop inductance is substantially 0.

Technical Solution

A paired low-characteristic impedance power line and ground line structure of the present invention includes a laminated sheet in which a metal wiring layer having a power line and a ground line is provided on the surface of an insulating sheet, an insulating thin-film layer provided so as to cover the metal wiring layer, and a resistive layer provided on the surface of the insulating thin-film layer.
The insulating thin-film layer may be provided in accordance with the surface shape of the laminated sheet on which the metal wiring layer is provided, and the resistive layer may be provided in accordance with the surface shape of the insulating thin-film layer.
The resistive layer may be a film in which homogeneous films of a metal or a semiconductor, or clustered grains of a metal or a semiconductor having a sheet resistance of 10 to 1000 $\Omega$ per square are layered.
The thickness of the resistive layer may be 20 to 1000 nm.
The thickness of the insulating thin-film layer may be 20 to 10000 nm.
The power line and the ground line may satisfy the relationships (i) and (ii):

(i) the ratio (t/w) of the thickness t of a wire and the width w of the wire in a short-side direction is less than or equal to 0.5.
(ii) the ratio (s/w) of the spacing s between adjacent wires and the width w of the wire in the short-side direction is 0.1 to 1.

The paired low-characteristic impedance power line and ground line structure of the present invention may further include a protective layer provided on the surface of the resistive layer.

Advantageous Effects

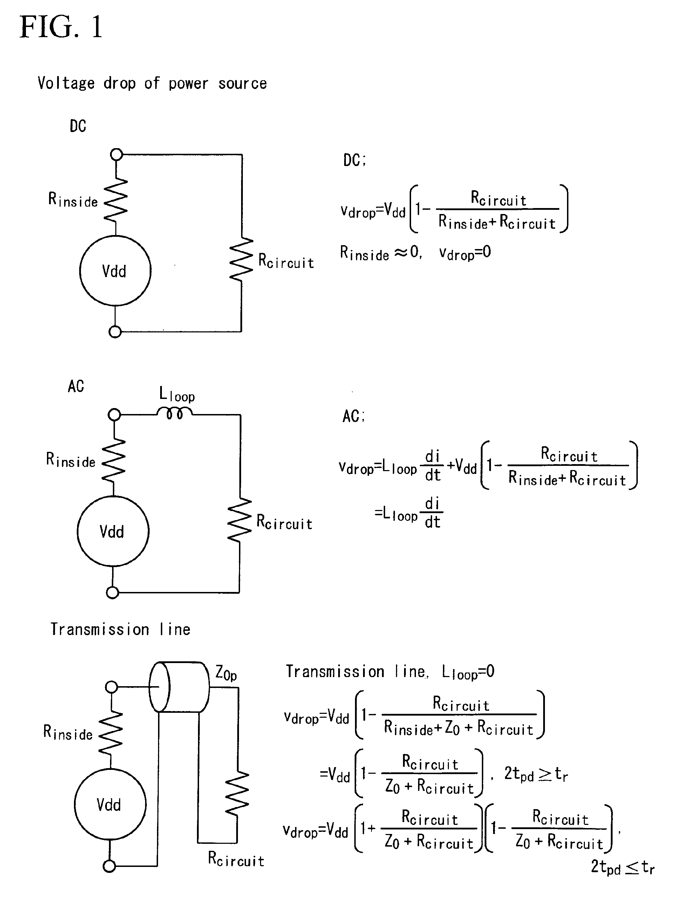

According to the present invention, a paired low-characteristic impedance power line and ground line structure in which loop inductance is substantially 0 can be provided, and a power supply circuit which is suitable for a frequency of 100 GHz can be produced. A principle that loop inductance becomes 0 will be first described with reference to FIG. 1.
In a DC circuit, a power source includes a Vdd power source, internal resistance $R_{inside}$ of the power source, and load resistance $R_{outside}$ of a load circuit, and the direct-current voltage drop is described in $V_{drop}$ of the DC. However, in an equivalent circuit of an alternating current, a $V_{drop}$ described in AC is applied due to the influence of parasitic inductance $L_{loop}$ corresponding to the loop area of the circuit, and power (the effect of L is in proportion to the current change rate) may not be supplied to an instantaneous switch transistor.
In a circuit described as Transmission line, a paired power line and ground line are used as a transmission line, and the circuit loop area becomes 0, such that a change is made to a circuit system of a resistive parameter having characteristic impedance enables to follow an instantaneous switch. This is the principle of this proposal. There is a direct-current resistive component by time $t_{pd}$ at which electrical energy passes through the transmission line at light speed, and a reflection is made by a mismatch portion of the characteristic impedance. Therefore,in FIG. 1, the $V_{drop}$ expression changes depending on the time. However, it is possible to follow the instantaneous switch. Meanwhile, if the value of the characteristic impedance is large, a direct current of $V_{drop}$ increases. Therefore, the characteristic impedance $Z_0$ of the paired power line and ground line is preferably small. In order to decrease the characteristic impedance, a paired planar structure is considered in which the power line and the ground line are arranged on a plane in parallel. In the following Expression (1), the width and thickness of each of the power line and the ground line are w and t, respectively. The pitch distance between the wires (an inter-center distance of both wires) is d, the specific dielectric constant of an insulator which covers around the power line and the ground line area is $\varepsilon_r$, and the vacuum dielectric constant is $\varepsilon_0$. A $Z_0$ which is less than or equal to 30 Ω is difficult to obtain with practical dimensions.

$$Z_0=(1/\pi)(\sqrt{\mu_r\mu_0/\varepsilon_r\varepsilon_0})(\ln(\pi(d-w)/(w+t)+1) \ldots (1)$$

As can be seen from Expression (1), it is difficult to produce a paired power line and ground line structure, in which $Z_0$ is less than or equal to 30 Ω, so as to have practical dimensions.
The present invention provides a paired power line and ground line structure in which a resistive layer (metamaterial) using a Droude expression described below is arranged, and photon-surface plasmon exchange is carried out, such that $Z_0$ becomes less than or equal to several Ω with practical dimensions, thereby realizing a low-characteristic impedance power supply which corresponds to a high-speed power source in a frequency band of 100 GHz.

Brief Description of Drawings

FIG. 1 is a circuit diagram which explains the principle.
FIG. 2 is a perspective view of an example of paired low-characteristic impedance power line and ground line structure of the present invention.
FIG. 3 is a plan view of an example of the paired low-characteristic impedance power line and ground line structure of the present invention.
FIG. 4 is a sectional view of an example of the paired low-characteristic impedance power line and ground line structure of the present invention.
FIG. 5 is a sectional view of an example of the paired low-characteristic impedance power line and ground line structure of the present invention.
FIG. 6 is a diagram illustrating grains in a resistive layer.
FIG. 7 is a diagram illustrating grains in a resistive layer.
FIG. 8 is a diagram showing an example of the state of grains in a resistive layer.
FIG. 9 is a diagram showing another example of the state of grains in a resistive layer.
FIG. 10 is a sectional view of a paired low-characteristic impedance power line and ground line structure used in the present invention.

Best Mode for Carrying Out the Invention

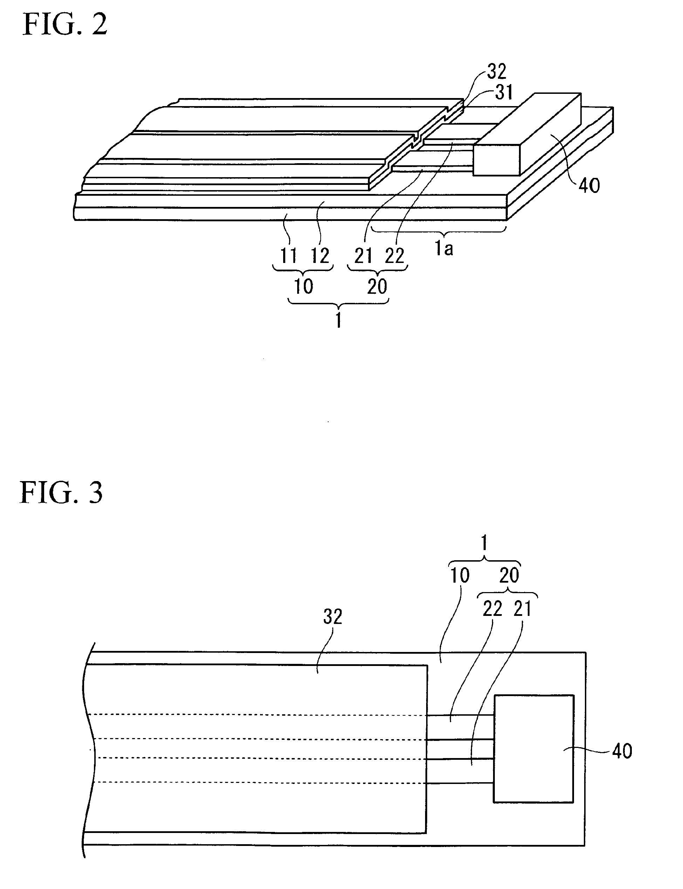

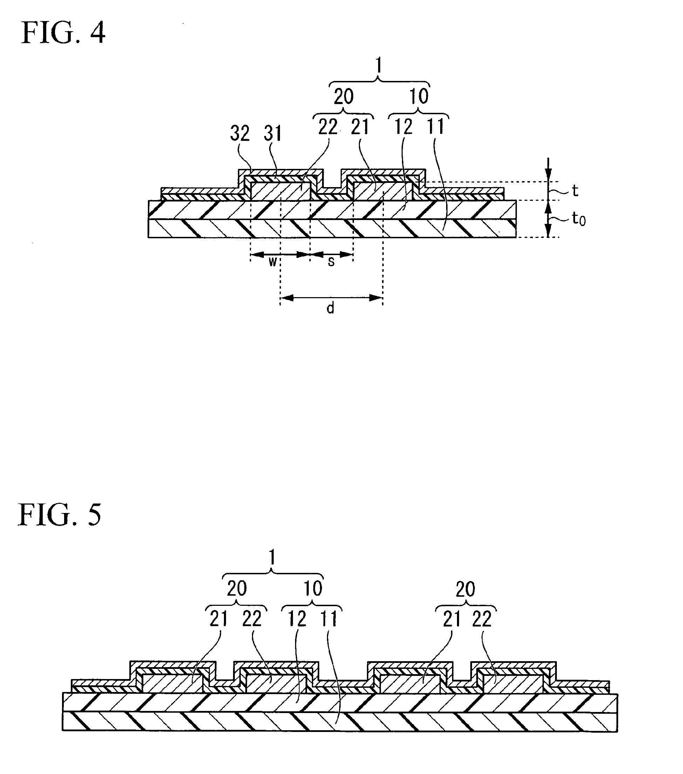

FIG. 2 is a perspective view of an example of a paired low-characteristic impedance power line and ground line structure of the present invention, FIG. 3 is a plan view, and FIG. 4 is a sectional view. In FIGS. 2 and 3, a partial structure for explanation is shown, however, this structure may be extended or folded without limitation.

A paired low-characteristic impedance power line and ground line structure has a laminated sheet 1 in which a metal wiring layer 20 having a power line 21 and a ground line 22 is provided on the surface of an insulating sheet 10, which has a base insulating sheet 11 and an underlayer base insulating sheet 12, an insulating thin-film layer 31 provided so as to cover the power line 21 and the ground line 22 conformally (that is, in accordance with the surface shape of the laminated sheet 1 on which the metal wiring layer 20 is provided), and a resistive layer 32 provided on the surface of the insulating thin-film layer 31 conformally (that is, in accordance with the surface shape of the insulating thin-film layer 31).

If necessary, a protective layer 33 (not shown) may be provided on the surface of the resistive layer 32.

The paired low-characteristic impedance power line and ground line structure may be embedded in a printed wiring board or the like.

(Laminated Sheet)

The laminated sheet 1 is, for example, a printed wiring board.

(Insulating Sheet)

The insulating sheet 10 is made of, for example, an organic insulating material, such as glass fiber reinforced epoxy resin, epoxy resin, polyester, PET (polyethylene terephthalate), PPC (polyester polycarbonate), polyvinylidene, polyimide, or polystyrene.

The thickness of the insulating sheet 10 may be set such that the insulating sheet 10 functions as a base material.

(Metal Wiring Layer)

The power line 21 and the ground line 22 are expanded in a strip-shaped long-side direction of the metal wiring layer 20. One end portion of each of the power line 21 and the ground line 22 is connected to a power source 40, and the other end portion includes a branch and is connected to a load. The power line 21 and the ground line 22 are exposed at one portion 1 a of the laminated sheet 1. In the planar layout, the length of the exposed portion is preferably less than or equal to 5 mm.

A single pair of the power line 21 and the ground line 22 may be provided, or as shown in FIG. 5, multiple pairs of the power line 21 and the ground line 22 may be arranged in parallel. When multiple pairs are arranged, the power source 40 may be arranged for each pair, such that a multiple-power source circuit may be formed.

The power line 21 and the ground line 22 are preferably designed so as to substantially have the same low characteristic impedance from the power source 40 to the output end portion, and both end portions are connected to a decoupling capacitor. When a branch is present between the power source 40 to the output end portion, the characteristic impedance after the branch to the characteristic impedance before the branch is preferably 1/n where n is the number of branches.

The power line 21 and the ground line 22 preferably satisfy the following relationships (i) to (iii).

(i) the ratio (t/w) of the thickness t of a wire and the width w of the wire in a short-side direction is less than or equal to 0.5

(ii) the ratio (s/w) of the spacing s between adjacent wires and the width w of the wire in the short-side direction is 0.1 to 1

(iii) the ratio ($w/t_0$) of the width w of the wire in the short-side direction and the thickness to of the insulating sheet 10 is less than or equal to 5.

The width w of each of the power line 21 and the ground line 22 is preferably 10 $\mu$m to 1 mm, and 0.1 to 10 $\mu$m inside a chip.

The thickness t of each of the power line 21 and the ground line 22 is determined depending on the current capacity. When the current capacity is 300 mA, if the width w is 100 $\mu$m, the thickness t is preferably 20 $\mu$m.

(Insulating Thin-Film Layer)

The insulating thin-film layer 31 may be made of an organic insulating material.

In providing the insulating thin-film layer 31 conformally, coating, spin coating, sputtering, vapor deposition, or CVD may be used.

The insulating thin-film layer 31 electrically insulates the resistive layer 32, such that the power line 21 and the ground line 22 are electrically separated from each other and an appropriate voltage is applied between the power line 21 and the ground line 22.

The thickness of the insulating thin-film layer 31 is set so as to have a withstand voltage according to a voltage applied between the power line 21 and the ground line 22, which freely changes between 0.1 to 10 V.

The thickness of the insulating thin-film layer 31 is preferably as small as possible so as to disrupt the electromagnetic field balance between the power line and the ground line (that is, so as to promote photon-surface plasmon exchange described below). Therefore, the thickness of the insulating thin-film layer 31 is preferably 20 to 10000 nm.

(Resistive Layer)

The resistive layer 32 is preferably a film in which homogeneous films of a metal or a semiconductor, or clustered grains (crystal grains) of a metal or a semiconductor having sheet resistance 10 to 1000 $\Omega$ per square are layered so as to produce the surface plasmon effect.

Examples of the metal or semiconductor include at least one selected from a group consisting of Fe, Al, Ni, Ag, Mg, Cu, Si, and C, or an alloy or a eutectoid containing at least two selected from the group.

The resistive layer 32 is formed on the surface of the insulating thin-film layer 31 by sputtering, vapor deposition, plating, ion plating, CVD, or spraying. The resistive layer 32 may be formed on the surface of the protective layer 33 to produce a resistive sheet, and then the resistive sheet may be attached to the surface of the laminated sheet 1 through the insulating thin-film layer 31.

The resistive layer 32 may be formed to have a strip-shaped line width by photolithography or the like.

The thickness of the resistive layer 32 is preferably 20 to 1000 nm.

The resistive layer 32 may have conductivity or insulation, but this is not a fundamental issue. Thus, the resistive layer 32 may have a pinhole (defect, void), or the cluster may have an electrically independent islet.

The paired low-characteristic impedance power line and ground line structure of the present invention may be embedded in a multilayer printed wiring board. In the case of a multilayer printed wiring board, lines are arranged in a vertical direction, and it has been confirmed that, if the lines are arranged at a distance corresponding to the width w of the lines, there is little influence on the photo-surface plasmon exchange.

With the paired low-characteristic impedance power line and ground line structure of the present invention, the loop inductance substantially becomes 0 since the resistive layer 32 is provided so as to cover the metal wiring layer 20 through the insulating thin-film layer 31. As a result, the characteristic impedance of the paired power line and ground line is reduced. Hereinafter, the principle will be described in detail.

According to the Droude's dielectric function and permeability function, $\varepsilon_\omega$ and $\mu_\omega$ are expressed by Expressions (2) to (5).

$$\varepsilon_\omega = 1 - (\omega_{ep}{}^2/\omega^2) \dots (2)$$

$$\omega_{ep}{}^2 \equiv (n_e e^2)/(\varepsilon_0 m) \dots (3)$$

$$\mu_\omega = 1 - (\omega_{mp}{}^2/\omega^2) \dots (4)$$

$$\omega_{mp}{}^2 \equiv (n_p \chi^2)/(\mu_0 m) \dots (5)$$

Here, $n_e$ is the density of free electrons of the resistive layer, $n_p$ is the density of unpaired electrons of the resistive layer, e is the charge amount of electrons, m is the electron mass, and $\chi$ is the spin probability of unpaired electrons.

A case is taken into consideration where the resistive layer has a morphology in which conductive particles having clustered particles of Fe having a radius of 1000 nm are linked at the number density of 1 particle/18 $\mu m^3$. When Fe has one free electron per atom, the density of free electrons of iron becomes $8.4 \times 10^{22}$ electrons/$cm^3$. Thus, the free electron density on the surface of iron becomes 2/3 power of $8.4 \times 10^{22}$ electrons/$cm^3$, that is, $1.9 \times 10^{15}$ elec-

trons/cm$^2$. However, the free electron density of the surface becomes smaller than the value since the free electrons are trapped by the surface-absorbed atoms. If it is assumed that the rate of decrease of free electrons due to trapping is $10^{-3}$, the density of free electrons on the surface of iron becomes $1.9 \times 10^{12}$ electrons/cm$^2$.

The radius of the conductive particles is 1 $\mu$m=$1 \times 10^{-5}$ cm. However, the amount of free electrodes per particle becomes $2.39 \times 10^3$ electrons since the surface area of the conductive particles becomes $4\pi(1 \times 10^{-5})^2 = 12.6 \times 10^{-10}$ cm$^2$. In addition, since the density of conductive particles is 1 particle/18 $\mu$m$^3$, the density of free electrons in the resistive layer becomes $n_e = 1.32 \times 10^{20}$ electrons/m$^3$.

The electron mass is m=$9.11 \times 10^{-31}$ kg, the charge amount of electrons is e=$1.6 \times 10^{-19}$ C, and the vacuum dielectric constant $\varepsilon_0 = 8.85 \times 10^{-12}$ F/m. If these values and $n_e = 1.32 \times 10^{20}$ electrons/m$^3$ are substituted in Expression (3), the relationship $\omega_{ep}^2 = 1.32 \times 10^{20} \times (1.6 \times 10^{-19})^2/(8.85 \times 10^{-12} \times 9.1 \times 10^{-31}) = 0.42 \times 10^{28}, \omega_{ep} = 0.65 \times 10^{14}$/S is established. Thus, $\omega_{ep}$ becomes the frequency of far ultraviolet light.

If $\omega$ is 1 GHz, the relation $\varepsilon_\omega = 1 - (6.5 \times 10^{13})^2/(2\pi \times 1 \times 10^9)^2 = 1 - 1.07 \times 10^8 = -1.07 \times 10^8$ is established by Expression (2), and a large value is obtained at $\varepsilon_r < -10^8$. When it comes to industrialization, although a large value can be substantially realized, $\varepsilon_\omega$ is set to $-10^6$ taking into consideration deterioration by two digits.

Meanwhile, it is assumed that $\mu_\omega$ is -10. This value is appropriate for the following reason.
As described above, the free electron density on the surface of iron is $1.32 \times 10^{20}$ electrons/cm$^2$. Of these, if the occurrence probability of unpaired electrons is $10^{-6}$, the density $n_p$ of unpaired electrons on the surface of iron becomes $1.32 \times 10^{14}$ electrons/cm$^2$. Then, the flux quantum $\chi = 2.07 \times 10^{-10}$ [Wb], and the vacuum permeability $\mu_0 = 1.25 \times 10^{-6}$ [N/A$^{-2}$], so a high frequency is obtained by Expression (5), that is, $\omega_{mp}^2 = 1.32 \times 10^{14} \times (2.07 \times 10^{15})^2/(1.25 \times 10^{-6} \times 9.1 \times 10^{-31}) = 4.97 \times 10^{20}$/s$^2$ and $\omega_{ep} = 2.23 \times 10^{10}$/s.

Similarly, if $\omega$ is 1 GHz, $\mu_\omega = 1 - (2.23 \times 10^{10})^2/(2\pi \times 1 \times 10^9)^2 = 1 - 0.125 \times 10^2 = -11$ is obtained. From this, it can be seen that, even when $\mu_\omega$ is -10, this value is appropriate.

Then, t is set to 0.001 m, w is set to 0.005 m, and d is set to 0.008 m, and these values, $\mu_\omega = -10$, and $\varepsilon_\omega = -10^6$ are substituted in Expression (1),
$Z_0 = 377 \times 0.0032 \times 0.943 = 1.13$ $\Omega$ is obtained.

This calculation is carried out on the assumption that all the free electrons and the magnetons effectively work at the resonance frequency for the free electrons or magnetons (unpaired electrons). Accordingly, it is not considered that the above-described calculation can be applied as it is. It is necessary to practically measure the number of effective free electrons or magnetons. Hereinafter, data which is obtained by measuring the effectiveness of an experimental model will be described. The electromagnetic field of a pair of electrical wires, that is, lines of electrical force or magnetic force which run over as a long distance as possible have weak coupling and easily exchange with other energy. That is, it is important that w is larger than t. A photon which is a quantization unit of an electromagnetic wave can be efficiently converted into other energy, for example, surface plasmon or surface magnon. A paired line structure having a circular shape in cross-section is effective. This still falls within the scope of the invention.

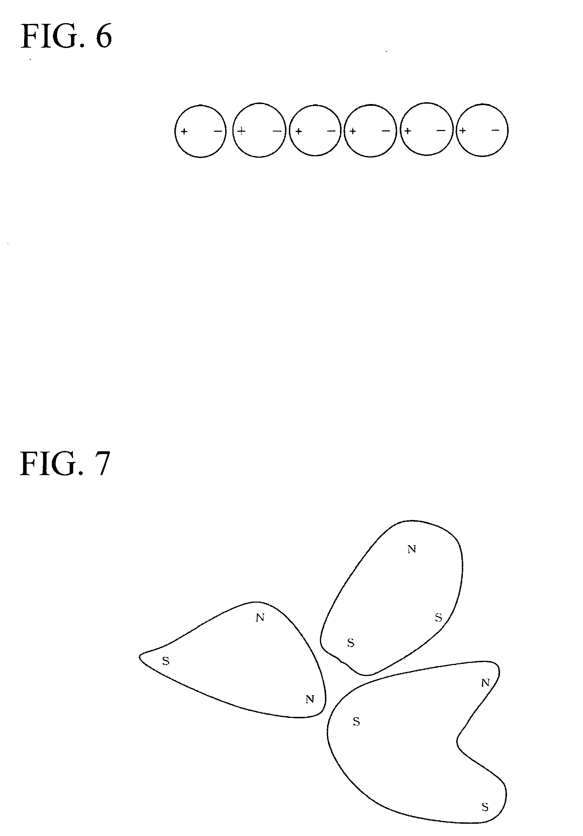

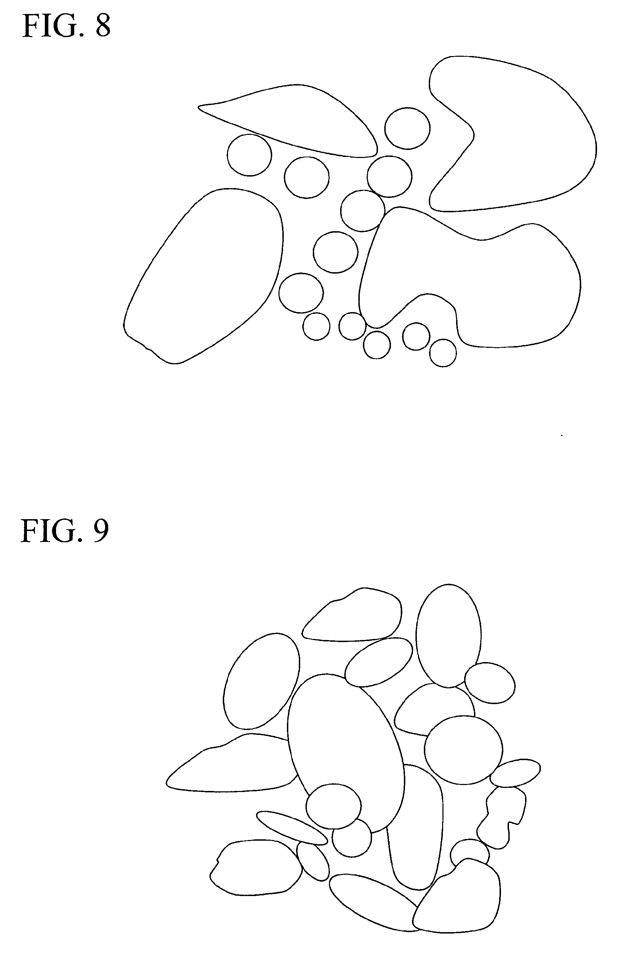

The resistive layer 32 is preferably provided conformally so as to cover the power line 21 and the ground line 22 as much as possible, such that the lines of electrical force and magnetic force which detour distantly are masked. If the electric field or magnetic field comes into contact with the metal surface or the semiconductor surface of the resistive layer 32, the free electrons undergo surface plasmon resonance, and the paramagnetic magnetons undergo surface magnon resonance, thereby absorbing photon energy. The propagation speed is a speed of the same order as lattice vibration, since plasmon and magnon are vibrations of electrons. That is, a speed (a speed slower by five digits than light speed) which is close to the speed of sound of a medium. For this reason, the energy density increases by five digits, as compared with light speed. With regard to the dielectric properties, since the resistive layer 32 is a thin film, the sheet resistance is high. In addition, as shown in FIG. 6, the particle system is composed of grains which are small and isotropically trued up, and the pluses and minuses between the grains are arranged in a chain shape, such that the specific dielectric constant increases. Meanwhile, with regard to the magnetic flux properties, the SN chain is produced in the same shape, and this makes magnetic flux coupling strong and decreases the specific permeability decreases. For this reason, as shown in FIG. 7, an irregular particle shape which has anisotropy to reduce the SN chain as much as possible with a comparatively large cluster is effective. The mixture state shown in FIG. 8 or the state having a mean particle shape shown in FIG. 9 which satisfies both conditions is preferable. Even when a metal or a semiconductor is not magnetized, a site appears which lost electrons due to an active dangling bond of the surface, and the powder surface area increases, such that the metal or semiconductor is magnetized. Thus, a metamaterial having a negative specific dielectric constant and specific permeability, that is, a double negative material is obtained. The paired power line and ground line structure of the present invention efficiently utilizes this phenomenon.

[Example]

Hereinafter, an example will be described.

(Thickness of Resistive Layer)

The cross-section of the resistive film was observed by using a transmission-type electron microscope (H9000NAR manufactured by Hitachi, Ltd.), and the thickness of the resistive layer was measured at five locations and averaged.

(Sheet Resistance)

Two thin-film metal electrodes (length 10 mm, width 5 mm, and inter-electrode distance 10 mm) formed by depositing gold on quartz glass were used, a resistive film was placed on the electrodes, and a load of 50g was applied to press an area of 10 mm×20 mm in the resistive film against the electrodes. In this state, inter-electrode resistance was measured by using a measurement current less than or equal to 1mA. This value was set as sheet resistance.

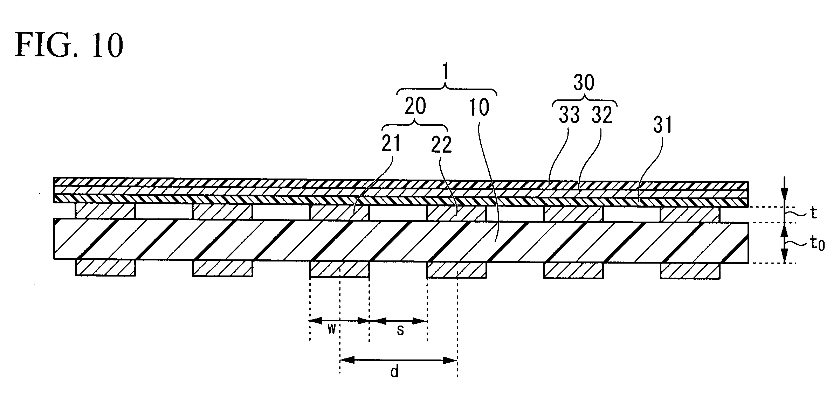

As an example, a laminated sheet 1 of 4 $\mu$m with nickel/gold plating on a copper foil of 38 $\mu$m for an FR-4 printed wiring board shown in FIG. 10 was prepared.

Nickel was physically deposited on the surface of a polyimide film having a thickness of 25 $\mu$m serving as the protective layer 33 by magnetron sputtering to form the resistive layer 32 having a thickness of 25 nm (sheet resistance: 30 $\Omega$ per square). Thus, the resistive sheet 30 was obtained. Then, the resistive sheet 30 was bonded to the laminated sheet 1 through an adhesive of 10 $\Omega$m (corresponding to the insulating thin-film layer 31) in a tenting state. Comparison was performed with respect to the laminated sheet 1 with no resistive sheet 30.

When w=1 mm, t=43 $\mu$m, s=1 mm, d=2 mm, the thickness of the insulating sheet 10 $t_0$=0.590 mm, the wire length 1=200 mm, and the tenting length=180 mm, the characteristic impedance and capacitance value between the power line 21 and the ground line 22 are shown in Table 1. Since the tenting state and the thickness of an adhesive (insulating thin-film layer 31) of 10 $\mu$m have no large effect, in this structure, Zo becomes 1/2.

[Table 1]

|  | No Resistive Layer | With Resistive Layer |
|---|---|---|
| Zo when $t_r$ = 35 ps | 80 $\Omega$ | 43 $\Omega$ |
| Capacitance at 100 kHz | 7.15 pF | 142 pF |

The present invention is not limited to the foregoing embodiment, and various modifications may be made without departing from the scope of the invention.

Industrial Applicability

The paired low-characteristic impedance power line and ground line structure of the present invention can be embedded in a printed wiring board or the like.

Explanation of References

1: LAMINATED SHEET

1A: END PORTION

10: INSULATING SHEET

11: BASE INSULATING SHEET

12: UNDERLAYER BASE INSULATING SHEET

20: METAL WIRING LAYER

21: POWER LINE

22:     GROUND LINE

30:     RESISTIVE SHEET

31:     INSULATING THIN-FILM LAYER

32:     RESISTIVE LAYER

33:     PROTECTIVE LAYER

40:     POWER SOURCE

**Claims**

1.  A paired low-characteristic impedance power line and ground line structure comprising:

    a laminated sheet in which a metal wiring layer having a power line and a ground line is provided on the surface of an insulating sheet;
    an insulating thin-film layer provided so as to cover the metal wiring layer; and
    a resistive layer provided on the surface of the insulating thin-film layer.

2.  The paired low-characteristic impedance power line and ground line structure according to claim 1,
    wherein the insulating thin-film layer is provided in accordance with the surface shape of the laminated sheet on which the metal wiring layer is provided, and
    the resistive layer is provided in accordance with the surface shape of the insulating thin-film layer.

3.  The paired low-characteristic impedance power line and ground line structure according to claim 1,
    wherein the resistive layer is a film in which homogeneous films of a metal or a semiconductor, or clustered grains of a metal or a semiconductor having sheet resistance of 10 to 1000 $\Omega$ per square are layered.

4.  The paired low-characteristic impedance power line and ground line structure according to claim 1,
    wherein the thickness of the resistive layer is 20 to 1000 nm.

5.  The paired low-characteristic impedance power line and ground line structure according to claim 1,
    wherein the thickness of the insulating thin-film layer is 20 to 10000 nm.

6.  The paired low-characteristic impedance power line and ground line structure according to claim 1,
    wherein the power line and the ground line satisfy the relationships (i) and (ii):

    (i) the ratio (t/w) of the thickness t of a wire and the width w of the wire in a short-side direction is less than or equal to 0.5
    (ii) the ratio (s/w) of the spacing s between adjacent wires and the width w of the wire in the short-side direction is 0.1 to 1.

7.  The paired low-characteristic impedance power line and ground line structure according to claim 1, further comprising:

    a protective layer provided on the surface of the resistive layer.

# FIG. 1

Voltage drop of power source

DC

DC;

$$v_{drop}=V_{dd}\left(1-\frac{R_{circuit}}{R_{inside}+R_{circuit}}\right)$$

$R_{inside}\approx 0, \quad v_{drop}=0$

AC

AC;

$$v_{drop}=L_{loop}\frac{di}{dt}+V_{dd}\left(1-\frac{R_{circuit}}{R_{inside}+R_{circuit}}\right)$$

$$=L_{loop}\frac{di}{dt}$$

Transmission line

Transmission line, $L_{loop}=0$

$$v_{drop}=V_{dd}\left(1-\frac{R_{circuit}}{R_{inside}+Z_0+R_{circuit}}\right)$$

$$=V_{dd}\left(1-\frac{R_{circuit}}{Z_0+R_{circuit}}\right), \quad 2t_{pd}\geq t_r$$

$$v_{drop}=V_{dd}\left(1+\frac{R_{circuit}}{Z_0+R_{circuit}}\right)\left(1-\frac{R_{circuit}}{Z_0+R_{circuit}}\right),$$

$$2t_{pd}\leq t_r$$

FIG. 2

FIG. 3

FIG. 4

FIG. 5

FIG. 6

FIG. 7

FIG. 8

FIG. 9

FIG. 10

## INTERNATIONAL SEARCH REPORT

| | International application No. |
|---|---|
| | PCT/JP2009/059386 |

**A. CLASSIFICATION OF SUBJECT MATTER**
*H05K1/02(2006.01)i, H05K3/28(2006.01)i, H05K9/00(2006.01)i*

According to International Patent Classification (IPC) or to both national classification and IPC

**B. FIELDS SEARCHED**

Minimum documentation searched (classification system followed by classification symbols)
H05K1/02, H05K3/28, H05K9/00

Documentation searched other than minimum documentation to the extent that such documents are included in the fields searched
Jitsuyo Shinan Koho          1922-1996   Jitsuyo Shinan Toroku Koho   1996-2009
Kokai Jitsuyo Shinan Koho    1971-2009   Toroku Jitsuyo Shinan Koho   1994-2009

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2004-259722 A  (Kanji OTSUKA), 16 September, 2004 (16.09.04), Full text; all drawings & US 2004/0207432 A1    & TW 000252580 B & KR 10-2004-0076215 A  & CN 001525564 A | 1-7 |
| A | JP 2005-033495 A  (Fujikura Ltd.), 03 February, 2005 (03.02.05), Abstract & US 2004/0227580 A1 | 1-7 |
| A | WO 2007/105555 A1  (Shin-Etsu Polymer Co., Ltd.), 20 September, 2007 (20.09.07), Par. Nos. [0001], [0020] to [0094] & JP 2007-243007 A | 1-7 |

| ☒ | Further documents are listed in the continuation of Box C. | ☐ | See patent family annex. |
|---|---|---|---|

* Special categories of cited documents:
"A" document defining the general state of the art which is not considered   to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 21 July, 2009 (21.07.09) | 04 August, 2009 (04.08.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
|---|
| PCT/JP2009/059386 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2005-287055 A  (Matsushita Electric Industrial Co., Ltd.), 13 October, 2005 (13.10.05), Full text; all drawings & JP 3723202 B         & US 2004/0124942 A1 & US 2005/0280486 A1    & WO 2004/013928 A1 & CN 001669176 A | 1-7 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008134348 A

- JP 2006135036 A